# EUROPEAN PATENT APPLICATION

(11) **EP 1 531 498 A2**
(43) Date of publication of application: **18.05.2005**
(21) Application number: 04024928.6
(22) Date of filing: 20.10.2004
(51) Int. Cl.: H01L 31/042, H01L 31/048

(54) **Solar cell module and manufacturing method therefor**

(30) Priority: 14.11.2003 JP 2003384525
(71) Applicant: CANON KABUSHIKI KAISHA, Ohta-ku, Tokyo (JP)
(72) Inventor: Matsushita, Masaaki, Tokyo (JP); Itoyama, Shigenori, Tokyo (JP); Kataoka, Ichiro, Tokyo (JP); Mukai, Takaaki, Tokyo (JP); Makita, Hidehisa, Tokyo (JP)
(74) Representative: Leson, Thomas Johannes Alois, Dipl.-Ing.

(57) **Abstract**

The solar cell module of the present invention includes a solar cell panel, a frame, and a back member provided on a back side of the solar cell panel, wherein the back member includes a joining portion for joining the back member to the back side of the solar cell panel, and a projection portion extending in a direction crossing the frame, and wherein the frame has a first engaging portion for engaging with the solar cell panel and the joining portion of the back member, and a second engaging portion for engaging with the projection portion of the back member, whereby the present invention provides a solar cell module having a high strength and a light weight at a low cost.

## Description

### BACKGROUND OF THE INVENTION

### Field of the Invention

The present invention relates to a solar cell module including a solar cell panel, a frame, and a back member having a projection portion, wherein the solar cell panel and the back member are engaged with the frame, thereby providing a solar cell module having a high strength and a light weight which is manufactured in a low cost.

### Related Background Art

Conventionally, many framed solar cell modules have been implemented as a photovoltaic power generating system which is installed on the roof of residential buildings to compensate for an electrical power supplied to the households. Often used as this type of the photovoltaic power generating system is one which employs a solar cell using a glass substrate and an aluminum frame provided as its frame member. Although an aluminum alloy used for this frame is lightweight and superior in weather resistance and workability, it is expensive, which is a factor increasing the cost of the solar cell module. Further, there has been a demand for improvement of the workability in mounting the solar cell module and increased size of the solar cell module in order to achieve a reduction in manufacturing cost by reducing the number of modules per power generation amount. In the case of the solar cell module using a glass substrate, an increase in the size of the solar cell module is achieved by a method of enhancing the strength of the glass, that is, increasing the thickness of the glass, or by a method of using tempered glass. However, when the thickness of the glass is increased as in the former method, this causes a reduction in light-transmissivity and a deterioration in power generation efficiency. Moreover, this causes an increase in weight, which means it is necessary to enhance the strength of the support member itself. Further, when tempered glass is used as in the latter method, this inevitably leads to an increase in cost.

While in the above module an aluminum foil or the like is used for the back plate, alternative arrangements have been proposed in which a rigid plate material such as an extruded aluminum material or a rolled iron plate is used instead of such an aluminum foil. Since the requisite strength can be secured by means of not only the glass plate but also the rigid plate material in this type of module, the module is advantageous in that it is not necessary to increase the thickness of the glass plate even when the module is enlarged in size. However, when manufacturing a solar cell module, it is necessary to bond components such as the EVA, the solar cell, and the extruded aluminum material at a high temperature of about 150°C. Since the requisite strength of the module cannot be secured when the rigid plate material is planar, the rigid plate material is subjected to the bending process such as corrugated-plate formation, resulting in an increase in the overall thickness thereof. This involves a problem that it is impossible to use the vacuum lamination method which can easily ensure reliability.

In this regard, Japanese Patent Application Laid-Open No. 2000-114569 proposes, as a substrate-integrated type thin-film solar cell module in which a thin-film solar cell is formed directly on a glass, a solar cell module which can ensure strength even when enlarged in size without increasing the thickness of a transparent panel such as a glass plate or using tempered glass and which provides high reliability. That is, disclosed therein is a solar cell module including a solar cell panel formed by successively stacking a thin-film solar cell element directly formed on a glass, a filler, and a back plate, wherein the back plate is formed by bonding together a planer back plate material and a non-planer back plate with an adhesive by using a vacuum lamination method and is provided with a contact part and a non-contact part that is separated apart from the planer back plate.

Further, Japanese Patent Application Laid-Open No. H10-294485 proposes providing means for, in enlarging a solar cell module in surface area, maintaining the physical strength of the solar cell module without considerably increasing the number of its components, thus making it possible to provide a solar cell module which is lightweight, inexpensive, and superior in output characteristics. The proposed solar cell module is composed of a solar cell panel including a solar cell element, a frame for fixing the outer edges of the solar cell panel, and means for outputting power from the solar cell panel, wherein a single or a plurality of ribs is provided in the frame for supporting and fixing the side surfaces of the solar cell panel.

The inventors of the present invention have been studying the possibility of realizing a solar cell module which is both lightweight and high in strength. The inventors of the present invention, however, have found that it is difficult to develop a solar cell module which is both lightweight and high in strength solely by extension from the conventional framed solar cell module technologies. Specifically, the following problems are involved.

In Japanese Patent Application Laid-Open No. 2000-114569, the frame and the ribs do not cross each other, which means that the structure provides no reinforcement against bending stress acting in the direction perpendicular to the light-receiving surface of the solar cell module.

Further, in Japanese Patent Application Laid-Open No. H10-294485, since the ribs are formed in the frame, the ribs must have the same height as the frame. This adds more than necessary weight to the ribs, presenting an obstacle to weight reduction. Further, even when the height of the ribs is made smaller than the thickness of the frame in this construction, a member such as a screw or the like is used for effecting fixation to the frame, which means a somewhat large thickness is required for the rib material, resulting in an increase in weight.

### SUMMARY OF THE INVENTION

The present invention has been made in view of the circumstances described above, and therefore an object of the present invention is to provide a solar cell module having a light weight and an enhanced mechanical strength.

As a result of extensive studies on the above-mentioned problems, the inventors of the present invention have reached a conclusion that the problems can be best overcome by the following constructions. That is, the present invention relates to:
(1) A solar cell module including a solar cell panel, a frame, and a back member provided on a back side of the solar cell panel, characterized in that the back member includes a joining portion for joining to the back side of the solar cell panel, and a projection portion extending in a direction crossing the frame, and that the frame has a first engaging portion for engaging with the solar cell panel and the joining portion of the back member, and a second engaging portion for engaging with the projection portion of the back member.
   Further, in the solar cell module of the present invention:
(2) It is preferable that the back member include a plurality of the projection portions extending in a direction crossing the frame, the projection portions being formed by bending, and that the back member is a single plate provided on an entire surface of a back side of the solar cell panel.
(3) It is preferable that a plurality of back members is provided on the back side of the solar cell panel.
(4) It is preferable that at an end portion of the solar cell module, a bending portion of at least one of a part of the solar cell panel and a part of the back member is bent so as to cover a cross section of the frame, and the bent portion is joined to the frame by a joining member.
(5) It is preferable that the solar cell panel is in electrical conduction with the frame by the joining member.
(6) It is preferable that the frame is an aluminum frame.
(7) It is preferable that the frame is provided only along a long side of the solar cell module.
(8) It is preferable that the projection portion of the back member has one of I-shaped, U-shaped, and V-shaped cross sections.
(9) It is preferable that the projection portion is provided more densely at an end portion of the solar cell module than at a central portion of the solar cell module.
   Further, the present invention relates to:
(10) A method of manufacturing a solar cell module including a solar cell panel, a frame, and a back member provided on a back side of the solar cell panel, including the steps of: forming the back member which includes a joining portion for joining to the back side of the solar cell panel, and a projection portion extending in a direction crossing the frame; providing the frame with a first engaging portion for engaging with the solar cell panel and the joining portion of the back member, and a second engaging portion for engaging with the projection portion of the back member; providing the back member having the projection portion on the back side of the solar cell panel; and engaging the solar cell panel and the back member with the first fitting portion and the second fitting portion to fix them to one another.

### BRIEF DESCRIPTION OF THE DRAWINGS

Fig. 1 is a schematic view, as seen from the light-receiving surface side, of a solar cell module according to the present invention;
Fig. 2 is a schematic view, as seen from the non-light-receiving surface side, of the solar cell module according to the present invention;
Fig. 3 is a schematic view showing the construction of a first engaging portion of a frame engaged with a solar cell panel and a back member, and a second engaging portion of the frame engaged with a projection portion of the back member, in the solar cell module according to the present invention;
Fig. 4 is a schematic view, as seen from the light-receiving surface side, of a solar cell module according to Example 1 of the present invention;
Fig. 5 is a schematic view, as seen from the non-light-receiving surface side, of the solar cell module according to Example 1 of the present invention;
Fig. 6 is a schematic view, as seen from the light-receiving surface side, of a solar cell panel and a back member according to Example 1 of the present invention;
Fig. 7 is a schematic view, as seen from the non-light-receiving surface side, of the solar cell panel and the back member according to Example 1 of the present invention;
Fig. 8 is a schematic view showing the construction of an aluminum frame according to Example 1 of the present invention;
Fig. 9 is a schematic cross-sectional diagram of engaging portions according to Example 1 of the present invention;
Fig. 10 is a schematic diagram of the solar cell panel according to Example 1 of the present invention;
Fig. 11 is a schematic view of a ground terminal lead-out portion in the solar cell module according to Example 1 of the present invention;
Fig. 12 is a schematic diagram, as seen from the non-light-receiving surface side, of an amorphous/microcrystalline silicon stacked solar cell used in the solar cell panel according to Example 1 of the present invention;
Fig. 13 is an enlarged schematic view showing an electrical connection portion of the amorphous/microcrystalline silicon stacked solar cell used in the solar cell panel according to Example 1 of the present invention;
Fig. 14 is a schematic view, as seen from the light-receiving surface side, of a solar cell module according to Example 2 of the present invention;
Fig. 15 is a schematic diagram of a solar cell panel according to Example 2 of the present invention;
Fig. 16 is a schematic side view, as seen from the long side of the solar cell module, of the solar cell panel and a back member according to Example 2 of the present invention;
Fig. 17 is a schematic enlarged side view, as seen from the long side of the solar cell module, of a projection portion of the back member in the solar cell panel according to Example 2 of the present invention;
Fig. 18 is a schematic view showing an engaging portion of an aluminum frame engaged with the projection portion in the back member according to Example 2 of the present invention;
Fig. 19 is a schematic view, as seen from the non-light-receiving surface side, of a solar cell module according to Example 3 of the present invention;
Fig. 20 is a schematic view showing an engaging portion of a back member engaged with an aluminum frame according to Example 3 of the present invention; and
Fig. 21 is a cross-sectional view, as seen from the short side of the solar cell module, of engaging portions where the aluminum frame is engaged with a solar cell panel and the back member according to Example 3 of the present invention.

### DESCRIPTION OF THE PREFERRED EMBODIMENTS

Hereinafter, the embodiments of a solar cell module according to the present invention are described with reference to the drawings. It is to be noted, however, that the present invention is not limited to the embodiments described below.

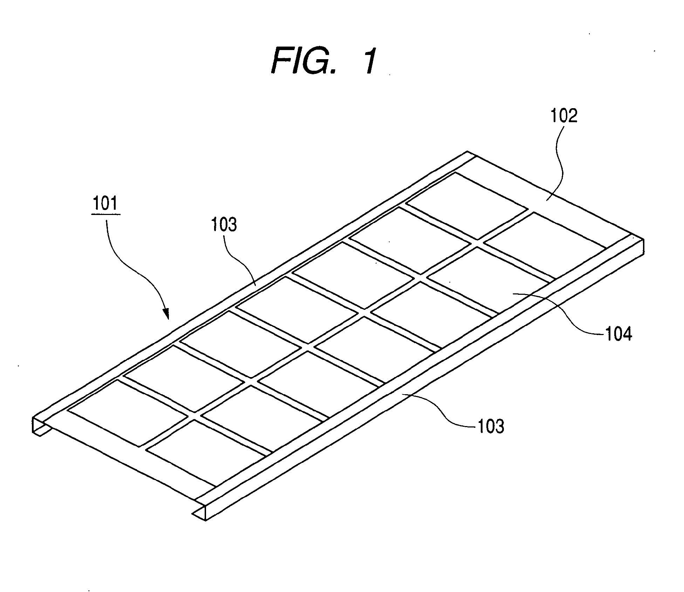

Fig. 1 is a schematic view of a solar cell module according to the present invention as seen from its light-receiving surface side. Reference numeral 101 denotes a solar cell module, 102 a solar cell panel, 103 a frame, and 104 a solar cell.

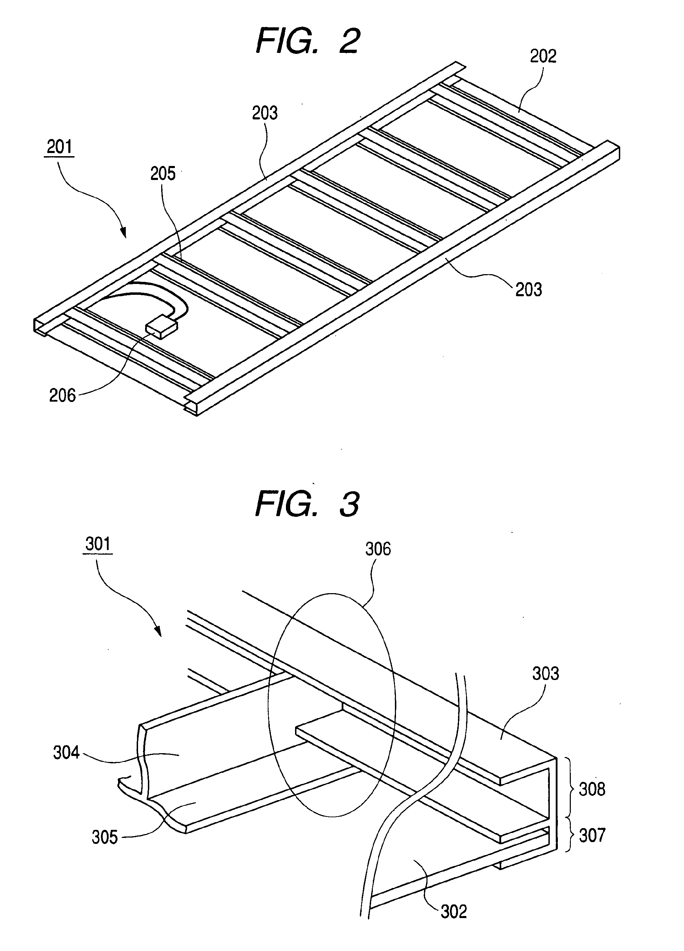

Fig. 2 is a schematic view of the solar cell module according to the present invention as seen from its non-light-receiving surface side. Reference numeral 201 denotes a solar cell module, 202 a solar cell panel, 203 a frame, 205 a back member, and 206 a junction box.

Fig. 3 is a schematic view showing a first engaging portion of the frame engaged with the solar cell panel and the back member, and a second engaging portion of the frame engaged with a projection portion of the back member, in the solar cell module according to the present invention. Reference numeral 301 denotes a solar cell module, 302 a solar cell panel, 303 a frame, 304 a projection portion of a back member, 305 a joining portion of the back member, 306 an engaging portion, 307 a first engaging portion of a frame, and 308 a second engaging portion of the frame.

The solar cell module of this embodiment is composed of the solar cell panel, the frame, and the back member provided on the back side of the solar cell panel. The back member is composed of the joining portion for joining onto the back side of the solar cell panel, and the projection portion extending in the direction crossing the frame. The frame includes the first engaging portion for engaging with the solar cell panel and the joining portion of the back member, and the second engaging portion for engaging with the projection portion of the back member.

In this embodiment, the back member having the projection portion is provided on the solar cell panel that easily deforms when subjected to stress. The frame, the solar cell panel, and the back member are engaged with one another, thereby making it possible to considerably enhance the mechanical strength of the solar cell module.

Hereinafter, the respective components are described in detail.

### (Solar Cell Panel)

There are no particular limitations on the type of the solar cell panel used in the present invention. A solar cell panel refers to a solar cell which is hermetically sealed with a covering member having weather resistance but which allows extraction of electrical output. Examples of solar cells to be used in the solar cell panel include an amorphous/microcrystalline silicon stacked solar cell, a crystalline silicon solar cell, a polycrystalline silicon solar cell, an amorphous silicon solar cell, a copper indium selenide solar cell, and a compound semiconductor solar cell. However, a thin-film solar cell having flexibility is preferred. In particular, a solar cell having a semiconductor active layer or the like as an photoelectric converting member formed on a flexible conductive substrate is preferred because such a solar cell can be readily enlarged in surface area and provides high reliability against bending stress, and particularly preferred is a stacked solar cell including an amorphous/microcrystalline silicon type 3-layer structure. Further, when the frame is provided along the long side of the solar cell panel, the bent portion on the short side of the panel may be bent so as to cover the frame end portion. In this case, when a construction is adopted in which the bent portion is joined to the frame by means of a joining member, the solar cell panel is mechanically fixed to the frame, making it possible to enhance the strength of the solar cell panel itself. Moreover, the electrical conduction between the frame and the solar cell panel can be effected at that joining portion, so that when, for example, the frame is made of aluminum and the aluminum frame is grounded to the earth, it is also possible to establish a ground for the solar cell panel.

### (Covering Member)

The covering material is used for the purpose of enhancing the weather resistance of a solar cell by protecting the solar cell against stain from the exterior or against external damage. Accordingly, transparency, weather resistance, and stain resistance are required of the covering material. Examples of suitably used materials which satisfy those requirements include a fluorine resin, an acrylic resin, a urethane resin, a silicone resin, and a glass. Examples of the method for covering a solar cell with such a material include a method of forming a film of the material and laminating it, a method of coating the material, and a method of bonding the material with an adhesive. Depending on the application, the covering material may be provided only on the front side of the solar or on both the front and back sides thereof. Further, when, in addition to the solar cell, a reinforcing member is also to be covered with the covering material, the covering material may be arranged so as to cover the end portion of the reinforcing member, thus preventing delamination or the like at the end portion.

### (Back Member)

There are no particular limitations regarding the back member used in the present invention. Examples of its material include: a metal steel such as a molten aluminum-plated steel plate, a molten zinc-plated steel plate, aluminum-zinc alloy plated steel plate, and a stainless steel plate; a plastic plate; and an FRP (Fiberglass Reinforced Plastic) sheet. Of those, preferred is a molten Zn-Al alloy-plated steel plate which is superior in weather resistance and rust resistance.

### (End Portion Bending Working)

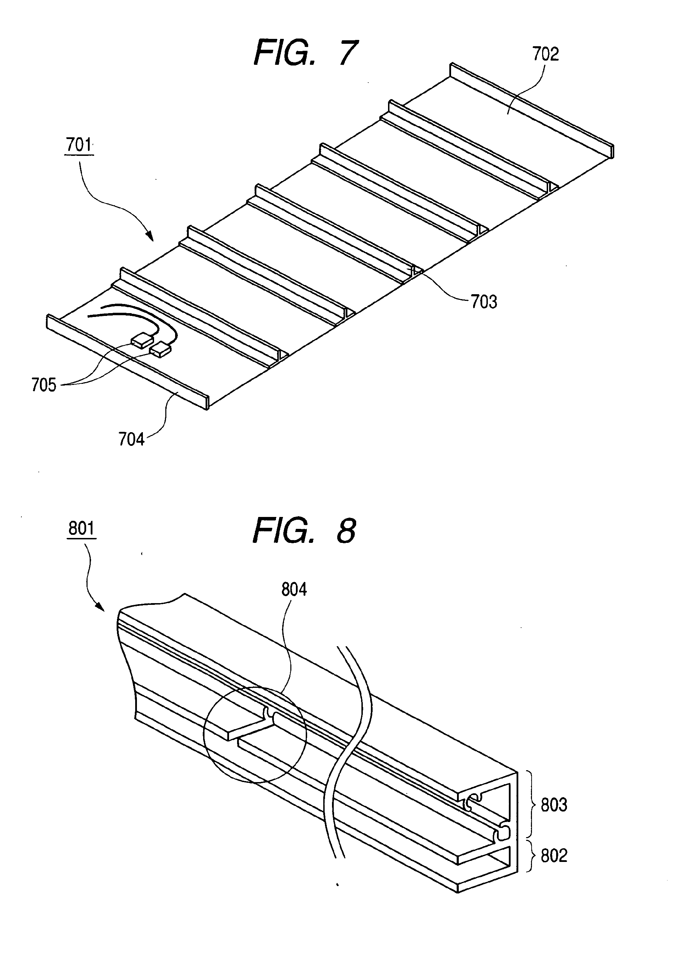

As shown in Fig. 7, for instance, the end portion (solar cell panel bending portion 704) of a solar cell panel 702 that does not include a solar cell is bent with a bender molding machine. At this time, care must be taken during the bending process so that the blade of the bender or the like does not abut the solar cell portion and a junction box 705.

### (Solar Cell Group)

A solar cell group consists of a plurality of solar cells that are electrically connected. As occasion demands, a schottky barrier diode or the like may be provided to prevent a reverse current flow into the solar cell due to shading or the like. The number of solar cells to be arranged in series is determined according to a desired electric power output.

Hereinafter, the present invention is described in detail by way of Examples. However, the present invention is not limited to the following Examples.

### (Example 1)

A solar cell module according to Example 1 of the present invention is composed of: a solar cell panel using an amorphous/microcrystalline silicon stacked solar cell that is covered with a covering material consisting of ETFE, EVA and PET, and integrally stacked with a molten Zn55%-AL-based alloy-plated steel plate (Galvalume steel plate); an aluminum frame; and a back member made of a Galvalume steel plate provided on the back side of the solar cell panel. The back member is composed of a joining portion for joining to the back side of the solar cell panel, and a projection portion extending in the direction crossing the aluminum frame. The aluminum frame has a first engaging portion for engaging with the solar cell panel and the joining portion of the back member, and a second engaging portion for engaging with the projection portion of the back member.

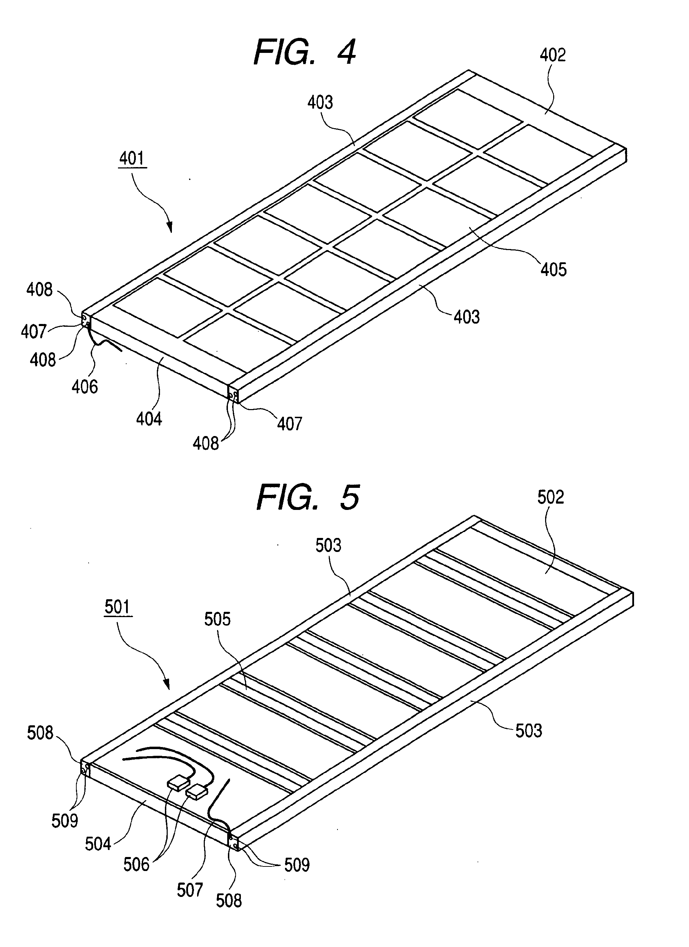

Fig. 4 is a schematic view of the solar cell module according to Example 1 as seen from its light-receiving surface side. Reference numeral 401 denotes a solar cell module, 402 a solar cell panel, 403 an aluminum frame, 404 a bending portion of the solar cell panel, 405 an amorphous/microcrystalline silicon stacked solar cell, 406 a ground wire, 407 an aluminum frame end portion cover, and 408 cover-fixing screws.

The aluminum frame is provided only along the long side of the solar cell module, and the end portion along the short side of the solar cell panel is bent toward the non-light-receiving surface side so as to cover the aluminum frame end portion. The aluminum frame end portion are provided with an aluminum plate and screws, serving as joining members for joining the solar cell panel to the aluminum frame.

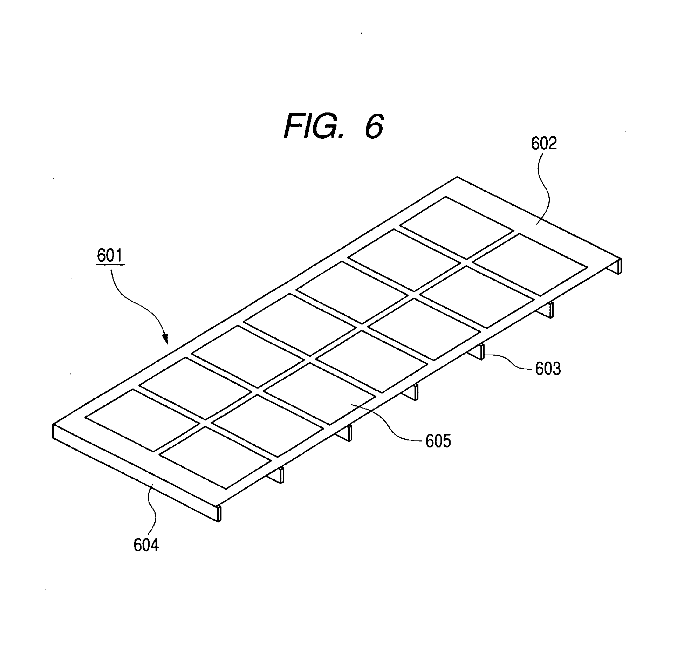

Fig. 5 is a schematic view of the solar cell module according to Example 1 as seen from its non-light-receiving surface side. Reference numeral 501 denotes a solar cell module, 502 a solar cell panel, 503 an aluminum frame, 504 a bending portion of the solar cell panel, 505 a back member, 506 a junction box, 507 a ground wire, 508 an aluminum frame end portion cover, and 509 cover-fixing screws.

The solar cell panel has on its back surface a plurality of the back members each having the projection portion and the joining portion, and the junction box.

Fig. 6 is a schematic view of the solar cell panel and the back member according to Example 1 as seen from its light-receiving surface side. Reference numeral 601 denotes a solar cell module, 602 a solar cell panel, 603 a back member, 604 a bending portion of the solar cell panel, and 605 an amorphous/microcrystalline silicon stacked solar cell.

Fig. 7 is a schematic view of the solar cell panel and the back member according to Example 1 as seen from its non-light-receiving surface side. Reference numeral 701 denotes a solar cell module, 702 a solar cell panel, 703 a back member, 704 a bending portion of the solar cell panel, and 705 a junction box.

Fig. 8 is a schematic view showing the construction of the aluminum frame according to Example 1. Reference numeral 801 denotes an aluminum frame, 802 a first engaging portion, 803 a second engaging portion, and 804 a back member fitting portion.

In the aluminum frame, there is provided, in addition to the first engaging portion and the second engaging portion that are continuous to each other, a engaging portion in conformity with the arrangement position and the cross-sectional shape of the projection portion provided on the back side of the solar cell panel.

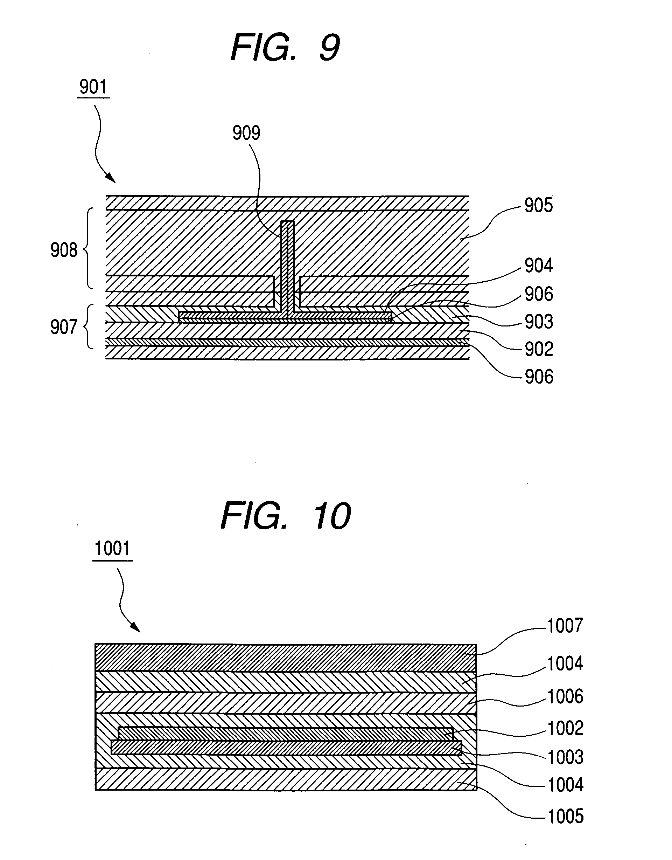

Fig. 9 is a schematic diagram showing the cross-sectional structure of the engaging portion according to Example 1. Reference numeral 901 denotes a solar cell module, 902 a solar cell panel, 903 a silicone adhesive, 904 a joining portion of a back member, 905 an aluminum frame, 906 a silicone adhesive, 907 a first engaging portion, 908 a second engaging portion, and 909 a projection portion of the back member.

The back member having the projection portion is provided on the back surface of the solar cell panel with the silicone adhesive. Further, for the purpose of filling the gap for the aluminum frame, the silicon adhesive is also applied in the space between the solar cell panel and the back member, and the aluminum frame.

Fig. 10 is a schematic diagram of the solar cell panel according to Example 1. Reference numeral 1001 denotes a solar cell panel, 1002 an amorphous/microcrystalline silicon stacked solar cell, 1003 a fiber glass, 1004 EVA, 1005 ETFE, 1006 PET, and 1007 a molten Zn55%-Al-based alloy-plated steel plate.

The integrated stacked structure of the solar cell panel described above makes it possible to also enhance the strength of the solar cell panel itself considerably. Further, the solar cell is covered with the covering material, and the glass fiber is further provided on the light-receiving surface of the solar cell, whereby the solar cell provides excellent anti-scratch property.

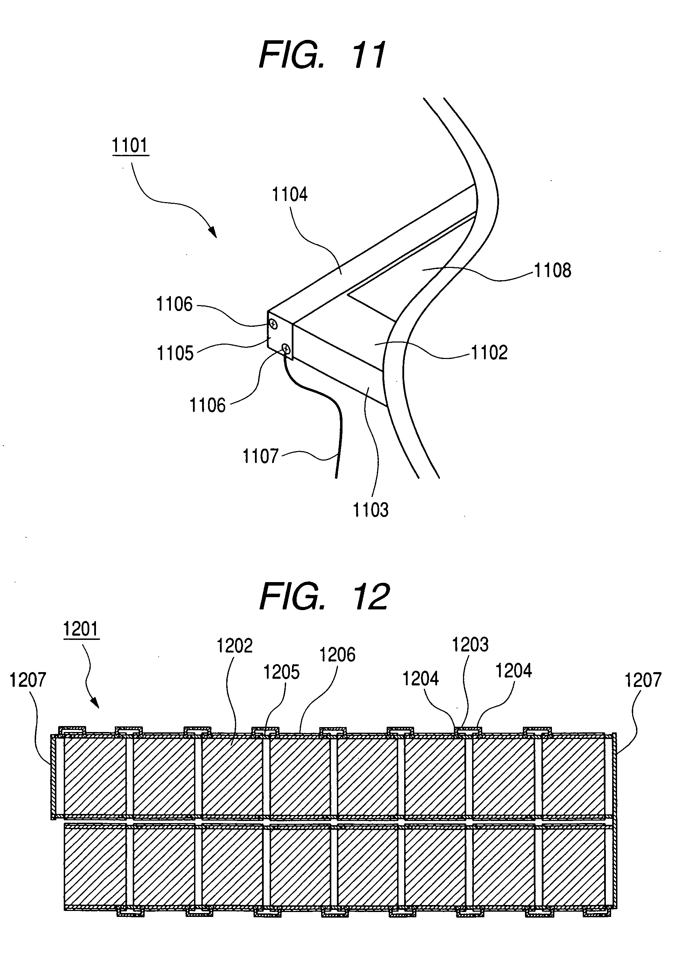

Fig. 11 is a schematic view showing a ground terminal lead-out portion in the solar cell module according to Example 1. Reference numeral 1101 denotes a solar cell module, 1102 a solar cell panel, 1103 a bending portion of the solar cell panel, 1104 an aluminum frame, 1105 an aluminum frame end portion cover, 1106 cover-fixing screws, 1107 a ground wire, 1108 an amorphous/microcrystalline silicon stacked solar cell.

The end portion of the solar cell panel is bent toward the non-light-receiving surface side so as to cover the cross section of the aluminum frame, and is fixed to the aluminum frame by means of a fixing member consisting of the aluminum frame end portion cover and the cover-fixing screws. Since the cover-fixing screws provide the electrical conduction between the solar cell panel and the aluminum frame, by leading out the ground wire from those screws, it is possible to ground the solar cell panel and the aluminum frame at the same time. While in Example 1 the aluminum frame end portion cover is used, this should not be construed restrictively; it is also possible to fix the bending portion of the solar cell panel and the aluminum frame with screws without providing such a cover, and the ground wire is led out from the fixing portion.

Fig. 12 is a schematic diagram, as seen from the non-light-receiving side, of the amorphous/microcrystalline silicon stacked solar cell used in the solar cell panel according to Example 1. Reference numeral 1201 denotes a solar cell group, 1202 an amorphous/microcrystalline silicon stacked solar cell, 1203 a schottky barrier diode, 1204 a diode terminal, 1205 a solar cell positive terminal, 1206 a solar cell negative terminal, and 1207 an interconnector.

In Example 1, 16 sheets of amorphous/microcrystalline silicon stacked solar cells are connected in series, and the schottky barrier diode is provided to each of the amorphous/microcrystalline silicon stacked solar cells.

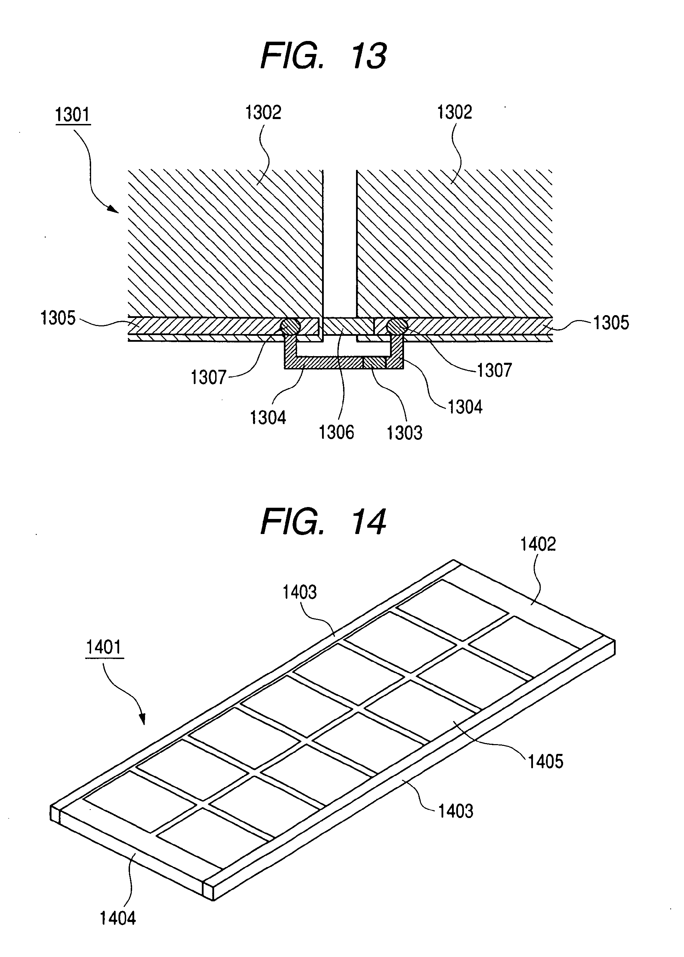

Fig. 13 is a schematic enlarged view of an electrical connection portion of the amorphous/microcrystalline silicon stacked solar cell used in the solar cell panel according to Example 1. Reference numeral 1301 denotes an electrical connection portion of an amorphous/microcrystalline silicon stacked solar cell, 1302 an amorphous and micro-crystalline stacked solar cell, 1303 a schottky barrier diode, 1304 a diode terminal, 1305 a solar cell negative terminal, 1306 a solar cell positive terminal, and 1307 a diode terminal connecting portion.

In the amorphous/microcrystalline silicon stacked solar cell, the positive terminal is arranged on the light-receiving surface side thereof, with a part of the positive terminal extending beyond the amorphous/microcrystalline silicon stacked region to be serially connected by soldering with the negative terminal arranged on the non-light-receiving surface side of the solar cell. The diode can be connected so as to straddle the solar cell. This construction allows the serial connection of the solar cells and the placing of the diodes to be performed only on the back side of the solar cells, thereby making it possible to considerably improve the workability of mounting.

In this way, it is possible to provide a lightweight and low-cost solar cell module having satisfactory mechanical strength.

### (Example 2)

A solar cell module according to Example 2 of the present invention is composed of: a solar cell panel using a plurality of amorphous/microcrystalline silicon stacked solar cells covered with a covering material consisting of ETFE, EVA and PET; an aluminum frame; and a back member consisting of a molten Zn55%-Al-based alloy-plated steel plate provided on the back side of the solar cell panel and having a plurality of projection portions formed by bending.

Fig. 14 is a schematic view of the solar cell module according to Example 2 as seen from its light-receiving surface side. Reference numeral 1401 denotes a solar cell module, 1402 a solar cell panel, 1403 an aluminum frame, 1404 a bending portion of a back member, and 1405 an amorphous/microcrystalline silicon stacked solar cell.

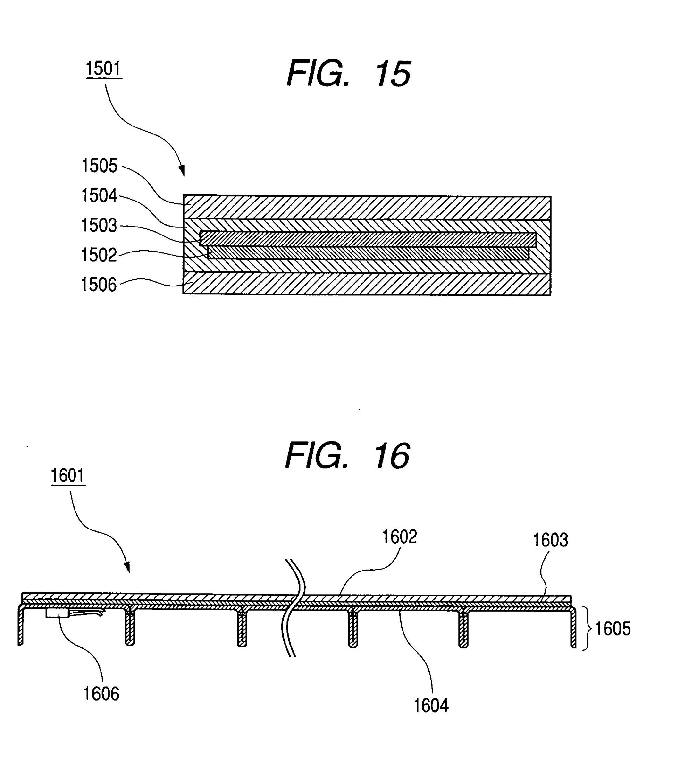

Fig. 15 is a schematic diagram of the solar cell panel according to Example 2. Reference numeral 1501 denotes a solar cell panel, 1502 an amorphous/microcrystalline silicon stacked solar cell, 1503 a glass fiber, 1504 EVA, 1505 ETFE, and 1506 PET.

Fig. 16 is a schematic side view of the solar cell panel and the back member according to Example 2 as seen from the long side of the solar cell module. Reference numeral 1601 denotes a solar cell module, 1602 a solar cell panel, 1603 a silicone adhesive, 1604 a back member, 1605 a projection portion of the back member, and 1606 a junction box.

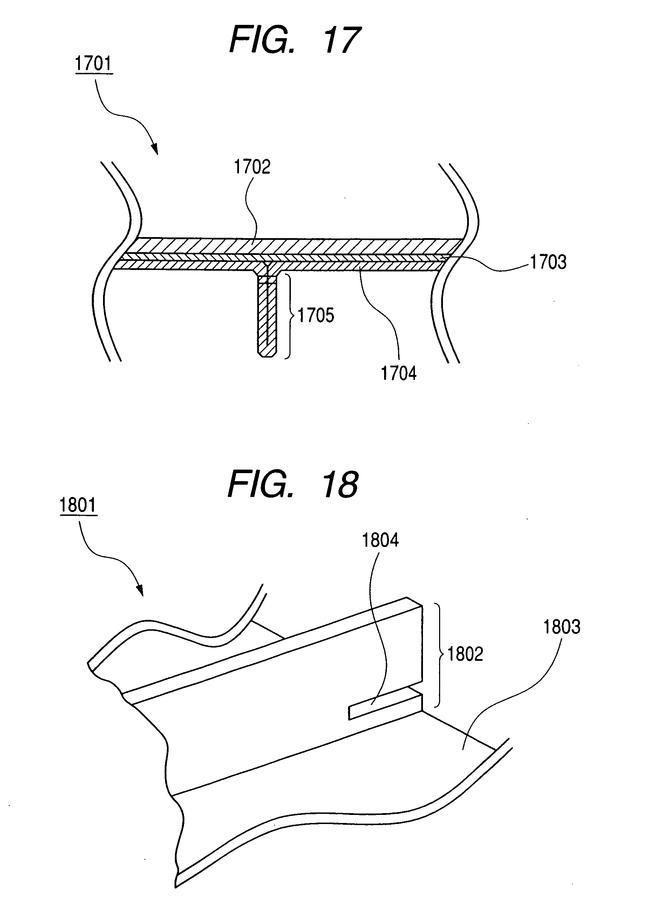

Fig. 17 is a schematic enlarged side view, as seen from the long side of the solar cell module, of the projection portion of the back member in the solar cell panel according to Example 2. Reference numeral 1701 denotes a solar cell module, 1702 a solar cell panel, 1703 a silicone adhesive, 1704 a back member, and 1705 a projection portion of the back member.

The back member and the solar cell panel are bonded together for fixation with the silicone adhesive. The back member is provided with a plurality of the projection portions formed by bending a single sheet and extending in the direction perpendicular to the aluminum frame. The height of the solar cell module, including the height of the projection portion of the back member, is set to be not larger than the sum of the respective heights of the first engaging portion and the second engaging portion of the aluminum frame.

Fig. 18 is a schematic view showing the engaging portion of the projecting portion of the back member engaged with the aluminum frame according to Example 2. Reference numeral 1801 denotes a back member, 1802 a projection portion of the back member, 1803 a joining portion of the back member, and 1804 a engaging portion of the back member.

Prior to bending the back member, a cut is formed in the back member by punching at a position where the projecting portion is to be formed. Then, after the bending process, this cut portion is engaged with the aluminum frame.

In this way, the solar cell module can be provided with ease which is equipped with the back member having the plurality of projection portions.

### (Example 3)

A solar cell module according to Example 3 of the present invention is composed of: a solar cell panel using a plurality of amorphous/microcrystalline silicon stacked solar cells covered with a covering material consisting of ETFE, EVA and PET; an aluminum frame; and a back member consisting of a coated zinc steel plate provided on the back side of the solar cell panel and having a plurality of projection portions formed by bending.

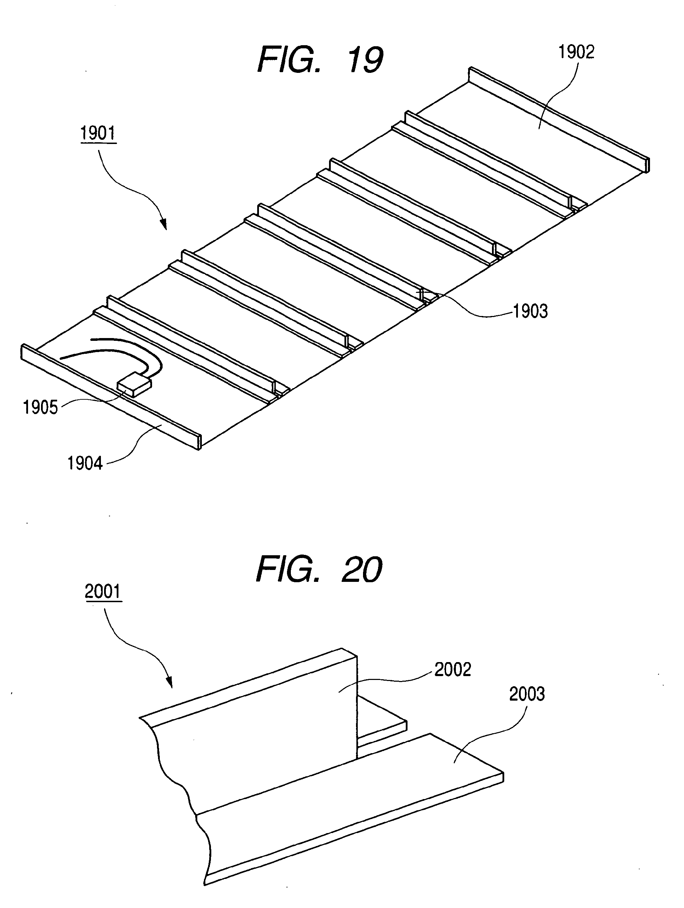

Fig. 19 is a schematic view of the solar cell module according to Example 3 as seen from its non-light-receiving surface side. Reference numeral 1901 denotes a solar cell module, 1902 a solar cell panel, 1903 a back member, 1904 a bending portion of the solar cell panel, and 1905 a junction box.

Fig. 20 is a schematic view showing the construction of the engaging portion of the back portion engaged with the aluminum frame according to Example 3. Reference numeral 2001 denotes a back member, 2002 a projection portion of the back member, and 2003 a joining portion of the back member.

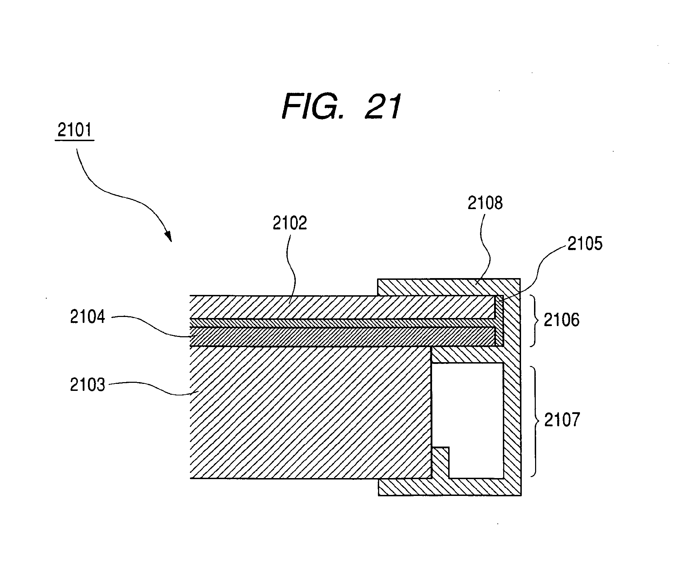

Fig. 21 is a schematic cross sectional view, as seen from the short side of the solar cell module, of the engaging portions of the aluminum frame engaged with the solar cell panel and the back member according to Example 3. Reference numeral 2101 denotes a solar cell module, 2102 a solar cell panel, 2103 a projection portion of a back member, 2104 a joining portion of the back member, 2105 a silicone adhesive, 2106 a first engaging portion, 2107 a second engaging portion, and 2108 an aluminum frame.

The projection portion of the back member used in Example 3 is cut away at both ends, thereby making it shorter than the width of the solar cell panel. This projection portion is fixed so as to be arranged in abutment with a projection portion formed between the first engaging portion and the second engaging portion of the aluminum frame. The back member is formed by cutting out a single plate by punching and then bending the same.

With this construction, even when deforming stress is applied on the solar cell panel, the solar cell panel is securely engaged with the aluminum frame, thereby making it less liable to deform.

According to the means (1) mentioned above, the projection portion of the back member is arranged in the direction crossing the frame, whereby the solar cell module can also exhibit strength against bending stress acting in the direction perpendicular to the light-receiving surface of the solar cell module. Further, the solar cell panel and the back member are jointed together, and the solar cell panel and the back member are engaged with the first engaging portion of the frame, whereby there is no need to use screws or the like to fix the back member and the frame. Therefore, the projecting portion needs only to have a thickness and a height which are required to provide the requisite strength and thus can be formed using a minimum material, thereby making it possible to provide a solar cell module which can achieve an enhanced strength and a reduced weight.

According to the means (2) mentioned above, the back member includes the plurality of projection portions, so that the stress exerted on the solar cell module is distributed, thereby making it possible to prevent damage to the solar cell module due to stress concentration. Further, the back member consists of a single sheet that is bent to form the projection portions, whereby the rigidity of the back member itself and hence the strength of the solar cell module can be enhanced. Moreover, the plurality of projection portions can be provided with ease, thereby making it possible to achieve a considerable reduction in manufacturing cost.

According to the means (3) mentioned above, the stress exerted on the solar cell panel and the solar cell module is distributed, thereby making it possible to achieve a further improvement in the strength of the solar cell module.

According to the means (4) mentioned above, the frame end portion does not get snagged on other objects, whereby damage or the like to the solar cell module can be prevented during the installation process. Further, the end portion of the solar cell panel and/or the back member is bent, thereby making it possible to secure the strength of the solar cell module without providing the frame along the short side of the solar cell module. Further, the back member and the frame are joined together by means of the joining member, thereby making it possible to achieve further an enhanced mechanical strength of the solar cell module.

According to the means (5) mentioned above, the electrical conduction is established between the solar cell panel and the frame. Therefore, by grounding the frame to the earth, it is also possible to ground the solar cell panel to the earth.

According to the means (6) mentioned above, it is possible to achieve a further reduction in the weight of the solar cell module.

According to the means (7) mentioned above, the aluminum frame is not provided along the short side of the solar cell module, thereby making it possible to achieve a reduced number of manufacturing steps and, moreover, a reduced weight.

According to the means (8) mentioned above, it is possible to considerably enhance the strength of the solar cell module in the direction perpendicular to the light-receiving surface thereof.

According to the means (9) mentioned above, the solar cell module can be reinforced in the vicinity of its end portion where stress is liable to concentrate, whereby the strength of the solar cell module can be enhanced. Moreover, the projection portions are sparsely provided in the vicinity of the central portion of the solar cell module where comparatively less stress concentration occurs, whereby it is possible to provide a solar cell module which is high in strength and lightweight without requiring an excess material.

According to the means (10) mentioned above, when producing a solar cell by the lamination method, the back member is formed after the lamination process, whereby a large-scale solar cell module can be produced with ease without involving a degassing failure. As a result, it is possible to achieve improved workability in mounting the solar cell module and reduced manufacturing cost due to the reduced number of modules per power generation amount.

As described above, in the solar cell module according to the preferred embodiments of the present invention, it is possible to ensure the mechanical strength of the solar cell module while achieving a reduction in its weight, by the engagement between the solar cell panel and the joining portion of the back member, and between the projection portion and the engaging portion of the frame. Further, after forming the solar cell panel, the back member is provided on the solar cell panel, whereby the solar cell module can be formed with ease.

This application claims priority from Japanese Patent Application No. 2003-384525 filed November 14, 2003, which is hereby incorporated by reference herein.

The solar cell module of the present invention includes a solar cell panel, a frame, and a back member provided on a back side of the solar cell panel, wherein the back member includes a joining portion for joining the back member to the back side of the solar cell panel, and a projection portion extending in a direction crossing the frame, and wherein the frame has a first engaging portion for engaging with the solar cell panel and the joining portion of the back member, and a second engaging portion for engaging with the projection portion of the back member, whereby the present invention provides a solar cell module having a high strength and a light weight at a low cost.

## Claims

1. A solar cell module comprising a solar cell panel, a frame, and a back member provided on a back side of the solar cell panel, wherein the back member includes a joining portion for joining to the back side of the solar cell panel, and a projection portion extending in a direction crossing the frame, and wherein the frame has a first engaging portion for engaging with the solar cell panel and the joining portion of the back member, and a second engaging portion for engaging with the projection portion of the back member.

2. A solar cell module according to Claim 1, wherein the back member comprises a plurality of projection portions extending in a direction crossing the frame, the projection portions being formed by bending, and wherein the back member is a single plate provided on an entire surface of a back side of the solar cell panel.

3. A solar cell module according to Claim 1, wherein a plurality of back members are provided on the back side of the solar cell panel.

4. A solar cell module according to Claim 1, wherein at an end portion of the solar cell module, a bending portion of at least one of a part of the solar cell panel and a part of the back member is bent so as to cover a cross section of the frame, and the bent portion is joined to the frame by a joining member.

5. A solar cell module according to Claim 4, wherein the solar cell panel is in electrical conduction with the frame by the joining member.

6. A solar cell module according to Claim 1, wherein the frame is an aluminum frame.

7. A solar cell module according to Claim 1, wherein the frame is provided only along a long side of the solar cell module.

8. A solar cell module according to Claim 1, wherein the projection portion of the back member has one of I-shaped, U-shaped, and V-shaped cross sections.

9. A solar cell module according to Claim 1, wherein the projection portion is provided more densely at an end portion of the solar cell module than at a central portion of the solar cell module.

10. A method of manufacturing a solar cell module including a solar cell panel, a frame, and a back member provided on a back side of the solar cell panel, comprising the steps of:
forming the back member which includes a joining portion for joining to the back side of the solar cell panel, and a projection portion extending in a direction crossing the frame;
providing the frame with a first engaging portion for engaging with the solar cell panel and the joining portion of the back member, and a second engaging portion for engaging with the projection portion of the back member;
providing the back member having the projection portion on the back side of the solar cell panel; and
engaging the solar cell panel and the back member with the first engaging portion and the second engaging portion to fix them to one another.
